Europäisches Patentamt

**European Patent Office**

**Office européen des brevets**

(19)

(11) Veröffentlichungsnummer: **0 046 976**
**A2**

(12) # EUROPÄISCHE PATENTANMELDUNG

(21) Anmeldenummer: **81106601.8**

(22) Anmeldetag: **25.08.81**

(51) Int. Cl.³: **G 06 F 11/20**

(30) Priorität: **29.08.80 DE 3032630**

(43) Veröffentlichungstag der Anmeldung:
**10.03.82 Patentblatt 82/10**

(84) Benannte Vertragsstaaten:
**FR GB**

(71) Anmelder: **SIEMENS AKTIENGESELLSCHAFT Berlin
und München
Postfach 22 02 61
D-8000 München 22(DE)**

(72) Erfinder: **Häusele, Hans, Dipl.-Ing.
Wetzelstrasse 4
D-8000 München 71(DE)**

(54) **Halbleiterspeicher aus Speicherbausteinen mit redundanten Speicherbereichen.**

(57) Die Erfindung betrifft einen Halbleiterspeicher aus Speicherbausteinen mit redunanten Speicherbereichen.
Zur Aufnahme der Informationen für die Ersatzschaltung
fehlerhafter Bitstellen in einem Speicherbaustein mit redundanten Speicherbereichen ist in dem Speicherbaustein ein
flüchtiger Hilfsspeicher vorgesehen. Jeder im Verlauf von
Wartungsarbeiten leicht auswechselbaren, eine Mehrzahl
von Speicherbausteinen umfassenden Baueinheit, z.B. einer
Flachbaugruppe, ist ein programmierbarer, nicht flüchtiger
Festwertspeicher zur Aufnahme der Ersatzschaltungsinformationen für alle in der Baueinheit zusammengefaßten
Speicherbausteine zugeordnet. Die Programmierung des
Festwertspeichers erfolgt vorzugsweise bei der Prüfung der
Baueinheit. Sie kann später ergänzt werden.

FIG 1

SIEMENS AKTIENGESELLSCHAFT          Unser Zeichen
Berlin und München                  80 P 2 0 7 0 E

Halbleiterspeicher aus Speicherbausteinen mit redundanten Speicherbereichen.

Die Erfindung bezieht sich auf einen Halbleiterspeicher nach dem Oberbegriff des Patentanspruches 1.

Speichersysteme auf Halbleiterbasis werden derzeit unter Verwendung von integrierten Speicherbausteinen aufgebaut. Dabei wird jeweils eine Anzahl Speicherbausteine (z.B. 36) auf einer steckbaren Flachbaugruppe oder auf einer vergleichbaren, zu Prüf-oder Wartungszwecken leicht auswechselbaren Baueinheit zusammengefaßt. Je nach der gewünschten Kapazität des Gesamtspeichers und der Kapazität der Speibausteine bzw. der Flachbaugruppen besteht der erstere aus einer mehr oder weniger großen Vielzahl von Flachbaugruppen. Im allgemeinen ist der Speicher mit einer Fehlerkorrektureinrichtung ausgestattet.

Ein sehr ernstes Problem bei der Herstellung von integrierten Speicherbausteinen ist die geringe Ausbeute an vollständig fehlerfreien Bausteinen. Man hat daher nach Möglichkeiten gesucht, wenigstens solche teilfunktionsfähigen Speicherbausteine noch einsetzen zu können, deren Fehler nur einzelne Bitstellen bzw. nur wenige Zeilen oder Spalten betreffen. Solche Maßnahmen haben aber eine verminderte Kapazität des Gesamtspeichers gegenüber dem mit fehlerfreien Speicherbausteinen erreichbaren Wert oder eine Überlastung der Fehlerkorrektureinrichtung zur Folge.

Es wurde daher schon vorgeschlagen, auf einer Flachbaugruppe/von beispielsweise 16 gegebenenfalls fehlerbehafteten Speicherbausteinen ohne redundante Speicherbereiche
eine Gruppe

She 1 Pe

und einen mit Sicherheit fehlerfreien Speicherbaustein anzuordnen. Der zusätzliche Speicherbaustein übernimmt den Ersatz der fehlerhaften Bitstellen in der Bausteingruppe. Ein programmierbarer Festwertspeicher wird durch eine Bausteinauswahladresse und die Spaltenadresse adressiert und gibt entsprechend seiner programmierten Übersetzungsfunktion eine Adresse für den Ersatzbaustein ab, wenn die Primäradresse eine fehlerhafte Bitstelle bezeichnet. Der Bausteinauswahldecoder für die Bausteingruppe wird dann gesperrt.

Der Aufwand für den programmierbaren Festwertspeicher ist sehr hoch. Bei 16 Speicherbausteinen mit je 16k bit müsste er beispielsweise 2048 adressierbare Speicherplätze für eventuelle Ersatzadressen umfassen, wovon naturgemäß nur wenige belegt sein können. Außerdem kann die Datenschnittstelle der Speicherbaugruppe nur so breit sein wie die Datenschnittstelle des zusätzlichen Speicherbausteins.

Durch die DE-AS 23 13 917 ist es bekannt, auf dem Speicherchip neben einem ersten, größeren Speicherbereich einen zweiten wesentlich kleineren Speicherbereich vorzusehen. Da im Fall der Fehlerfreiheit nur zu dem ersten Speicherbereich zugegriffen wird und seine Kapazität als die Kapazität des Speicherchips bzw. Speicherbausteins definiert ist, wird dieser Bereich im folgenden als Speicherhauptbereich bezeichnet. Entsprechend ist der zweite Bereich der redundante Speicherbereich oder Speicherersatzbereich. Seine Aufgabe ist es nämlich, soweit erforderlich, defekte Speicherzellen bzw. Wort-oder Bitleitungen im Speicherhauptbereich zu ersetzen. Zum Zweck der Ersatzschaltung sind bei der bekannten Anordnung auf dem Speicherchip Umschalteinrichtungen und eine programmierbarer Festwertspeicher zur Speicherung der hierzu benötigten Informationen vorhanden.

Bei der Bestückung einer Baugruppe mit derartigen Speicherbausteinen kann die Breite der Datenschnittstelle von und zur Baugruppe maximal ebenso viele Bit umfassen, wie Speicherbausteine vorhanden sind.

Einen Überblick über weitere Möglichkeiten für den vollwertigen Einsatz von fehlerhaften Speicherbausteinen mit Redundanz gibt die Literaturstelle "IEEE Journal of Solid-State Circuit", Vol.SC-13, No.5, Oktober 1978, Seite 698 bis 703. Unter anderem sind hier Betrachtungen über verschiedene Arten der Speicherung der Ersatzschaltungsinformationen angestellt. Als Beispiel ist "die Speicherung" durch Eingriff in die Verdrahtung auf dem Halbleiterchip mittels Laserstrahlen während oder nach einer ersten Überpfüfung des Chips aufgeführt. Als weiteres Beispiel ist der bereits erwähnte programmierbare Festwertspeicher angegeben. Beide Arten haben den Vorteil, daß die gespeicherte Information nicht verlorengeht, wenn die Betriebsspannung für den Speicherbaustein oder für den aus solchen Bausteinen aufgebauten Speicher abgeschaltet wird. Während die erste Methode jedoch sehr unflexibel ist und nachträgliche Änderungen nicht zuläßt, bedingt die Bereitstellung eines programmierbaren Festwertspeichers auf dem Chip im allgemeinen die Anwendung einer Technologie, die von der Technologie für die Herstellung der übrigen Anordnungen auf dem Chip abweicht.

Diese Nachteile können durch einen flüchtigen Hilfsspeicher auf dem Speicherchip vermieden werden, dessen Inhalt allerdings beim Ausfall der Betriebsspannung verschwindet. Um zu vermeiden, daß der ganze Speicher anschließend für die Wiedergewinnung der einschlägigen Informationen erneut geprüft werden muß, wird in der genannten Literaturstelle vorgeschlagen, für den Gesamtspeicher einen Festwertspeicher, z.B. eine Magnetplatte, vorzusehen. Wenn jedoch bei der Wartung aus irgendwelchen Gründen eine Flachbaugruppe ausgewechselt werden muß, enthält der Festwertspeicher eine Information, die für die Ersatzbaugruppe nicht gilt. Der Speicher muß daher neu überprüft werden.

Der Erfindung liegt die Aufgabe zugrunde, die bekannte Anordnung, bei der die Speicherbausteine flüchtige Hilfsspeicher (Register) zur Aufnahme der Ersatzschaltungsinformationen enthalten und dem Gesamtspeicher ein Festwertspeicher zugeordnet ist, so abzuwandeln, daß der Austausch von Flachbaugruppen oder vergleichbarer, bei Wartungsarbeiten ohne besondere Umstände auswechselbarer kleinster Baueinheiten ohne anschließende Speicherprüfung zum Zweck der Wiedergewinnung der notwendigen Ersatzschaltungsinformationen für die betreffende Baueinheit möglich ist.

Gemäß der Erfindung wird diese Aufgabe mit Hilfe der im kennzeichnenden Teil des Patentanspruchs 1 aufgeführten Merkmale gelöst.

Die Erfindung wird nachstehend anhand von Ausführungsbeispielen unter Zuhilfenahme der Zeichnung näher beschrieben. Es zeigt darin

Fig.1 die Organisation einer Speicherbaugruppe gemäß der Erfindung,

Fig.2 das Schaltungsprinzip eines Speicherbausteins mit redundanten Speicherbereichen.

Für das Folgende wird beispielsweise angenommen, daß eine Speicherbaugruppe 36 Speicherbausteine mit einer 1 bit

0046976

80 P 2070.E

breiten Datenschnittstelle enthält. Zu allen Speicherbausteinen wird parallel zugegriffen. Demnach umfaßt die Schnittstelle der Baugruppe für Schreibdaten und Lesedaten je 36 Bit. Setzt man noch voraus, daß die Speicherbausteine eine Kapazität (im Speicherhauptbereich) vom 65k-bit besitzen, und die Spaltenadresse nach der Zeilenadresse eingegeben wird, dann besitzt der Adressenbus eine Breite von 8 Bit. Andere Organisationsformen sind selbstverständlich möglich, wobei gegebenenfalls noch eine Bausteinauswahladresse bereitgestellt werden muß.

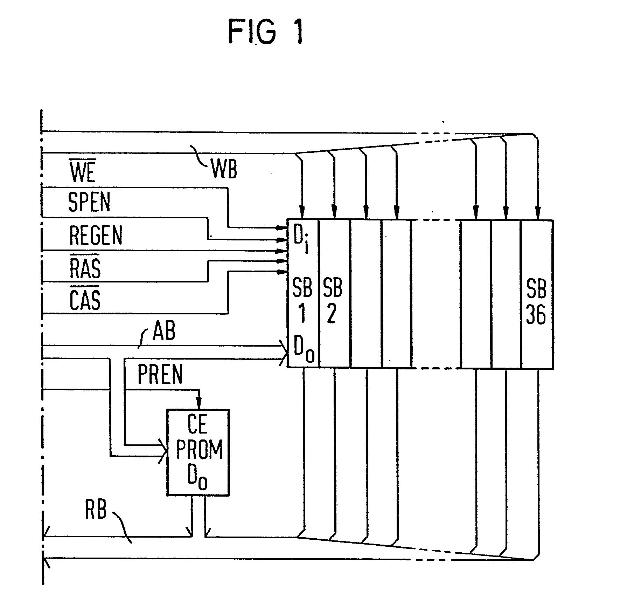

Die Figur 1 zeigt das Schaltungsschema einer Speicherbaugruppe mit einigen der 36 Speicherbausteine SB1 bis SB36, deren Schreibdateneingänge und Lesedatenausgänge je einen Datenbus WB bzw. RB bilden. Alle Speicherbausteine liegen parallel am Adressenbus AB. Ferner ist ein programmierbarer Festwertspeicher PROM vorhanden, der mit dem Adressenbus AB und Lesedatenbus RB verbunden ist. Der Festwertspeicher PROM enthält die Informationen für die Ersatzschaltung fehlerhafter Teile der Speicherhauptbereiche durch die Speicherersatzbereiche in allen Speicherbausteinen der Speicherbaugruppe. Diese Informationen werden während der Prüfung der Speicherbaugruppe oder daran anschließend eingegeben.

Die Figur 1 zeigt auch noch die Anschlüsse für das Schreib-Lese-Auswahlsignal $\overline{WE}$ und für die Freigabesignale SPEN, REGEN und PREN, auf deren Bedeutung noch eingegangen wird. Ferner sind die Eingänge für die Signale $\overline{RAS}$ und $\overline{CAS}$ zur Steuerung der zeitlich gestaffelten Eingabe von Zeilen- und Spaltenadressen dargestellt.

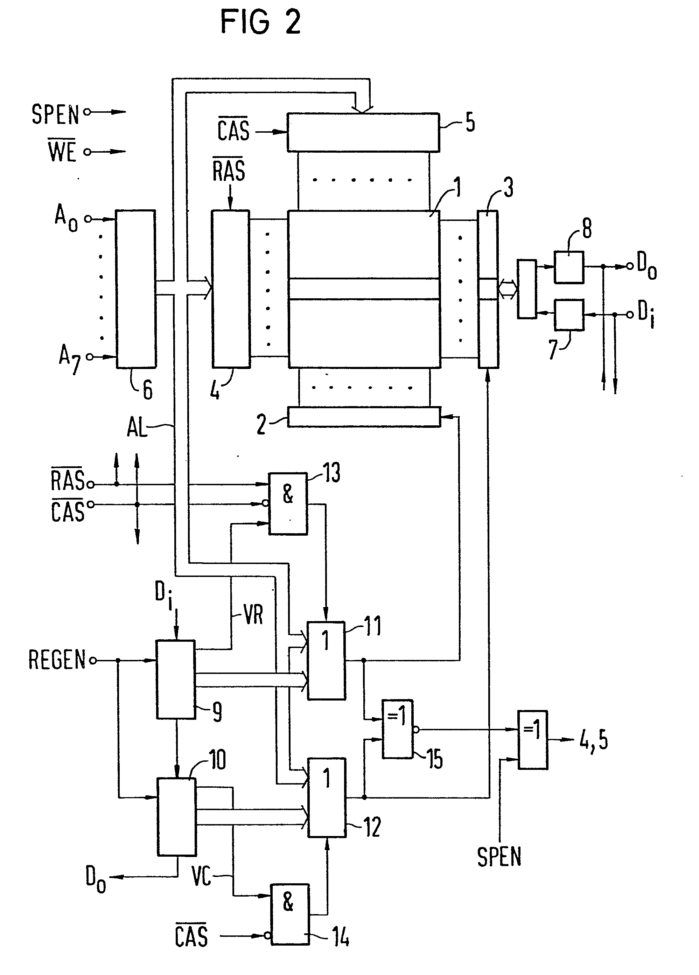

Die Figur 2 zeigt das vereinfachte Schaltungsprinzip eines Speicherbausteins mit dem matrixförmigen Speicherhauptbereich 1 üblicher Art sowie eine Ersatzzeile 2 und eine Ersatzspalte 3, die zusammen den Speicherersatzbereich bilden.
Es können auch jeweils mehrere Ersatzzeilen und Ersatzspalten vorgesehen sein. Zur Auswahl einer bestimmten
Zeile und Spalte im Speicherhauptbereich dienen der Zeilenadressendecoder 4 und der Spaltenadressendecoder 5. Mindestens der Zeilenadressendecoder 4 muß wegen der zeitlich aufeinanderfolgenden Adresseneingabe für Zeile und
Spalte Speichereigenschaften besitzen. Die Eingabe der
Adressenbit $A_0$ bis $A_7$ erfolgt über eine Adressenpufferschaltung 6, von der aus die Adressen über die Adressenleitungen AL weitergegeben werden. Ein bei einem Zugriff
zu dem Speicherbaustein einzuschreibendes Bit gelangt über
den Dateneingang $D_i$ und eine Dateneingangspufferschaltung
7 zur Speichermatrix. Entsprechend wird ein aus der
Speichermatrix ausgelesenes Bit über eine Datenausgangspufferschaltung 8 und über den Datenausgang $D_o$ nach außen
geleitet.

Vom Speicherersatzbereich 2,3 abgesehen, gleicht der bisher beschriebene Teil des Speicherbausteins völlig bekannten Ausführungen. Weitere Einzelheiten können daher den Unterlagen für handelsübliche Speicherbausteine entnommen
werden (vergl. z.B. Firmendruckschrift der Mostek Corp.,
Carollton,USA "Memory Data Book and Designers Guide",
Febr.1968, Seite 107 bis 116, Baustein MK4116). Ein näheres Eingehen hierauf erübrigt sich daher. Die Figur 2
zeigt jedoch noch ein erstes und zweites Rekonfigurationsregister (Ersatzschaltungsadressregister) 9 bzw. 10 zur
Aufnahme von Rekonfigurationsadressen, d.h. der Adressen
je einer defekten Zeile und Spalte im Speicherhauptbereich.
Einzelne defekte Bitstellen, die weniger häufig auftreten,
können zeilen-oder spaltenweise ersetzt werden. Die Rekonfigurationsregister 9, 10 enthalten noch sogenannte Gültigkeitsbit VR und VC, die angeben, ob eine Ersatzschaltung überhaupt vorgenommen werden soll. Letzteres ist wichtig, weil alle möglichen, einschließlich der aus lauter binären Nullen bestehenden Inhalte der Rekonfigurationsregister 9, 10 Adressen für den Speicherhauptbereich darstellen und auch dann zu Ersatzschaltungen führen würden, wenn diese gar nicht notwendig sind.

Den Rekonfigurationsregistern 9 und 10 sind durch die genannten Gültigkeitsbits VR und VC aktivierbare Vergleicher 11 und 12 zugeordnet. Jedem Vergleicher 11,12 wird außer dem Inhalt des betreffenden Registers die über die Adresseneingänge anliegende externe Adresse des Speicherhauptbereiches zugeleitet. Da nun voraussetzungsgemäß das eine Rekonfigurationsregister 9 der Ersatzzeile zugeordnet ist und die Adresse einer fehlerhaften Zeile des Speicherhauptbereichs enthält, muß sichergestellt sein, daß der Vergleicher 11 die angeschlossene Ersatzzeile auch bei Übereinstimmung der externen Adresse mit der im Register 9 gespeicherten Adresse nur dann ansteuert, wenn die externe Adresse eine Zeilenadresse ist. Entsprechendes gilt in Spaltenrichtung.

Diese Bedingung ist in einem Speicherbaustein mit paralleler Eingabe von Zeilen-und Spaltenadressen durch entsprechende Verdrahtung ohne weiteres erreichbar. Bei der hier zugrundegelegten Organisation eines Speicherbausteins, die ähnlich der Organisation des bereits genannten Speicherbausteins MK4116 ist, wird durch die jede Adresseneingabe begleitenden Signale $\overline{RAS}$ und $\overline{CAS}$ bestimmt, ob eine Zeilen- oder Spaltenadresse vorliegt. Es ist also zweckmäßig, diese Signale bzw. deren invertierte Werte mit den Gültigkeitsbit VR und VC nach einer UND-Funktion zu verknüpfen und das Verknüpfungsergebnis zur Aktivierung der Vergleicher zu verwenden. Geht man in Übereinstimmung mit den bei dem bekannten Speicherbaustein vorliegenden Verhältnissen davon aus, daß das Signal $\overline{RAS}$ während eines ganzen
Lese-oder Schreibzugriffs wirksam ist, das Signal $\overline{CAS}$
aber erst nach Beendigung der Zeilenadresseneingabe beginnt,
dann ergeben sich die aus Figur 2 in symbolischer Darstellung ersichtlichen Verknüpfungen durch die UND-Glieder 13
(Zeile) und 14 (Spalte). Dabei ist wie üblich vorausgesetzt,
daß die UND-Bedingung erfüllt ist, wenn alle Eingangssignale
den höheren binären Signalpegel führen. Mindestens der Vergleicher 11 für die Zeilenadressen muß in der Lage sein,
das Vergleichsergebnis zu speichern, da die externe Zeilenadresse nur kurzzeitig verfügbar ist und alsbald durch
eine Spaltenadresse ersetzt wird.

Sind die Voraussetzungen für die Aktivierung eines Vergleichers erfüllt und sind auch die ihm angebotenen Adressen identisch, dann gilt die mit dem Ausgang des Vergleichers verbundene Ersatzzeile oder -spalte als ausgewählt.
Gleichzeitig werden die Adressdecoder 4 und 5 für den
Speicherhauptbereich gesperrt. Das geschieht über ein an
alle Vergleicherausgänge angeschlossenes NOR-Glied 15.

Die Rekonfigurationsregister 9,10 sollen bitseriell über
den Dateneingang $D_i$ ladbar und ebenso über den Datenausgang $D_O$ lesbar sein. Zur Auswahl der einzelnen Bitstellen
der Register sind daher Adressen erforderlich, die schrittweise erhöht (oder erniedrigt) werden. Die Festlegung
eines bestimmten Registers von zwei Registern 9 und 10
kann durch ein zusätzliches Adressenbit oder durch die
Signale $\overline{RAS}$ und $\overline{CAS}$ erfolgen. Sind mehrere Ersatzzeilen
und -spalten und demgemäß mehr als zwei Register vorgesehen, dann muß mindestens die Unterscheidung zwischen
den Registern der gleichen Art über die Adresse erfolgen.

0046976

Ein Zugriff zu den Rekonfigurationsregistern 9,10 kann wegen den mit dem Speicherbereich gemeinsamen Adress- und Datenwegen nur erfolgen, wenn das schon erwähnte Registerfreigabesignal REGEN anliegt. Das Freigabesignal SPEN für den Speicherbereich muß verschwinden.
Entsprechendes gilt umgekehrt.

Wegen des bitseriellen externen Zugriffs zu den Rekonfigurationsregistern 9,10 ist es zweckmäßig, diese als Schieberegister auszubilden, deren Inhalt innerhalb des Bausteins zum Zweck des Adressenvergleichs parallel abgefragt werden kann. In diesem Fall besteht auch die Möglichkeit, die beiden Rekonfigurationsregister 9 und 10 in Serie zu schalten und bei der Übernahme der Ersatzschaltungsinformationen aus dem Festwertspeicher PROM mit der bitweisen Eingabe der eine defekte Spalte des Speicherhauptbereichs betreffenden Information in das der Zeilenrichtung zugeordnete Rekonfigurationsregister 9 zu beginnen. Bei der anschliessenden Eingabe der Zeileninformation wird die Spalteninformation in das Spaltenregister 10 weitergeschoben, so daß schließlich die Ersatzschaltungsinformation für Zeile und Spalte in den jeweils dafür vorgesehenen Rekonfigurationsregistern 9 und 10 enthalten sind. Eine besondere Adressierung dieser Register durch ein zusätzliches Adressenbit oder durch die Signale $\overline{RAS}$ und $\overline{CAS}$ entfällt dann.
Die zuletzt beschriebene Variante ist in Figur 2 dargestellt.

Die ursprünglich aufgrund der Prüfung einer Speicherbaugruppe durch entsprechende Programmierung oder nach dem Abschalten der Versorgungsspannung nur in dem Festwertspeicher PROM enthaltenen Informationen für alle auf der Speicherbaugruppe befindlichen Speicherbausteine müssen vor Aufnahme oder Wiederaufnahme des Betriebes in die Rekonfigurationsregister 9,10 der einzelnen Speicherbausteine eingegeben werden.

Bevor auf Einzelheiten der Informationsübergabe näher eingegangen wird, soll zunächst die notwendige Speicherkapazität
des Festwertspeichers PROM abgeschätzt werden. Es wird wie
bisher zugrundegelegt, daß eine Speicherbaugruppe 36 Speicherbausteine mit je 65k bit Speicherkapazität enthält, zu
deren internen Adressierung je 8 Zeilenadressbit und 8
Spaltenadressbit gebraucht werden. Da je Speicherbaustein
eine Zeile und eine Spalte ersetzbar sein soll, ergibt das
16 Adressbit je Speicherbaustein. Dazu kommen noch 2 Gültigkeitsbit VR und VC. Bei 36 Speicherbausteinen macht das
zusammen 648 bit. Es kann als Festwertspeicher also beispielsweise ein handelsüblicher 256 x 4 bit TTL-PROM-Baustein
verwendet werden.

Eine Schwierigkeit ergibt sich dabei daraus, daß die Informationen aus dem Festwertspeicher nur in 4-bit-Worten
auf dem Lesedatenbus RB zur Verfügung gestellt werden. Da
es aber zweckmäßig ist, die gleichwertigen Bit der Rekonfigurationsadressen bzw. die gleichartigen Güligkeitsbit in
die entsprechenden Register aller 36 Speicherbausteine
gleichzeitig einzuschreiben, wird in folgender Weise vorgegangen:

Es laufen 9 Festwertspeicher-Lesezyklen hintereinander ab,
deren Lesedaten in einem Serviceprozessor, der für Bedienung
und Wartung in modernen DV-Systemen ohnehin vorhanden ist,
oder im Zentralprozessor zwischengespeichert und so umformatiert werden, daß daraus ein einziges 36 bit breites
Wort entsteht. Dieses Wort wird über den gemeinsamen Schreibdatenbus WB in die Speicherbausteine SD1 bis SD36 bzw.
in deren Rekonfigurationsregister eingegeben.

Der aus 9 Lesezyklen, der Umformatierung und einem Schreibzyklus bestehende Vorgang muß noch 17 mal wiederholt werden,
bis die ganze Ersatzschaltungsinformation in alle Speicherbausteine einer Speichergruppe eingeschrieben ist. Das vervielfacht sich noch entsprechend der Zahl der Speicherbaugruppen in einem Speichersystem.

Es ist noch darauf hinzuweisen, daß während eines Lesezyklus für den Festwertspeicher das Freigabesignal PREN anliegen muß, die Freigabesignale SPEN und REGEN dürfen nicht wirksam sein. Entsprechend ist das Signal REGEN während der Phase der Eingabe der Rekonfigurationsinformation in die Speicherbausteine wirksam. Es sei ferner noch erwähnt, daß die Eingabe von Ersatzschaltungsinformationen in die Rekonfigurationsregister 9 und 10 aufgrund neu aufgetretener Fehler auch während des laufenden Betriebs mit niedriger Priorität erfolgen kann. Gleichzeitig werden die in den fehlerbehafteten Teilen der Speicherhauptbereiche gespeicherten Daten in die Speicherersatzbereiche übergeführt. Die in den Lesedaten dabei möglicherweise enthaltenen Fehler werden durch die dem Speicher zugeordnete Fehlerkorrektureinrichtungen mit großer Wahrscheinlichkeit korrigiert.

6 Patentansprüche
2 Figuren

0046976

<u>Liste der Bezugszeichen</u>                     80 P 2070 E

| | |
|---|---|
| SB1 - SB36 | Speicherbaustein |
| PROM | Festwertspeicher |
| AB | Adressenbus |
| RB | Lesedatenbus |
| WB | Schreibdatenbus |
| $\overline{WE}$, $\overline{RAS}$, $\overline{CAS}$ | |
| SPEN, REGEN, PREN | Steuersignale |
| 1 | Speicherhauptbereich |
| 2 | Ersatzzeile |
| 3 | Ersatzspalte |
| 4 | Zeilenadressdecoder |
| 5 | Spaltenadressdecoder |
| 6 | Adressenpufferschaltung |
| 7 | Dateneingangspufferschaltung |
| 8 | Datenausgangspufferschaltung |
| $A_0 - A_7$ | Adresseneingänge (Adressenbit) |
| AL | Adressenleitungen |
| $D_i$ | Dateneingang |
| $D_o$ | Datenausgang |
| 9,10 | Rekonfigurationsregister |
| 11,12 | Vergleicher |
| 13,14 | UND-Glied |
| 15 | NOR-Glied |

80 P 2070 E

80 P 2070 E

Patentansprüche

1. Halbleiterspeicher aus Speicherbausteinen mit redundanten Speicherbereichen und mit Einrichtungen zur Ersatzschaltung fehlerhafter Speicherbereiche durch redundante Speicherbereiche, insbesondere mit einem bausteininternen flüchtigen Hilfsspeicher (Rekonfigurationsregister), zur Aufnahme der für die Ersatzschaltung benötigten Informationen, sowie mit einem bausteinexternen, nicht-flüchtigen Hilfsspeicher zur Aufnahme der für die bausteininterne Ersatzschaltung aller Speicherbausteine benötigten Informationen, d a d u r c h   g e k e n n z e i c h n e t, daß jeder im Verlauf normaler Wartungsarbeiten auswechselbaren kleinsten Baueinheit ein programmierbarer Festwertspeicher als nichtflüchtiger Hilfsspeicher zugeordnet ist und daß der Festwertspeicher (PROM) die Ersatzschaltungsinformationen für alle auf der Baueinheit zusammengefaßten Speicherbausteine (SB1 - SB 36) aufnimmt.

2. Halbleiterspeicher nach Anspruch 1, d a d u r c h   g e k e n n z e i c h n e t, daß der Festwertspeicher (PROM) an den für alle Speicherbausteine (SB1 - SB36) gemeinsamen Adressbus (AS) sowie an den gemeinsamen Lesedatenbus (RB) angeschlossen ist.

3. Halbleiterspeicher nach Anspruch 1 oder 2, d a d u r c h   g e k e n n z e i c h n e t, daß der bausteininterne flüchtige Hilfsspeicher (9,10) aus mindestens zwei Rekonfigurationsregistern (9,10) besteht, die als parallel abfragbare Schieberegister ausgebildet sind, deren Eingänge und Ausgänge für die serielle Eingabe und Ausgabe mit den Dateneingängen ($D_i$) und den Datenausgängen ($D_o$) der Speicherbausteine entsprechend verbunden sind.

4. Halbleiterspeicher nach Anspruch 3, d a d u r c h g e -
k e n n z e i c h n e t, daß die Rekonfigurationsregister
(9,10) in Serie geschaltet sind und daß die Eingabe der
Ersatzschaltungsinformationen für alle Rekonfigurationsregister (9,10) bitseriell über den Informationseingang
des in Schieberichtung ersten Rekonfigurationsregisters
(9) erfolgt.

5. Halbleiterspeicher nach Anspruch 3 oder 4, d a d u r c h
g e k e n n z e i c h n e t, daß die Rekonfigurationsregister (9,10) neben den Adressen fehlerhafter Zeilen
oder Spalten je ein Gültigkeitsbit (VR, VC) enthalten, das
angibt, ob eine Ersatzschaltung durchzuführen ist oder
nicht.

6. Verfahren zur Übergabe der in dem Festwertspeicher enthaltenen Ersatzschaltungsinformation in die Speicherbausteine einer Baueinheit das Halbleiterspeichers nach einem
der vorhergehenden Ansprüche, g e k e n n z e i c h n e t
durch folgende Schritte:
a) Ein der Breite der Datenschnittstelle des Festwertspeichers (PROM) entsprechendes Wort wird gelesen, in einem
Serviceprozessor oder in dem Zentralprozessor einer Datenverarbeitungsanlage zwischengespeichert und, wenn
erforderlich, auf ein der Breite der Datenschnittstelle
der Baueinheit entsprechendes Wort umformatiert
b) je ein Bit des gegebenenfalls neu gebildeten Wortes
wird gleichzeitig in so viele Speicherbausteine eingegeben als die Datenschnittstelle der Baueinheit Bit
umfaßt,
c) der Vorgang wird wiederholt, bis alle im Festwertspeicher
gespeicherten Ersatzschaltungsinformationen in den Speicherbausteinen vorliegen.

## FIG 1

WE
SPEN
REGEN
RAS
CAS

WB

$D_i$

SB 1   SB 2   SB 36

$D_0$

AB

PREN

CE PROM $D_0$

RB

2/2

FIG 2

0046976